Europäisches Patentamt

European Patent Office

Office européen des brevets

(19)

(11) Veröffentlichungsnummer : **0 096 326
B1**

# (12) EUROPÄISCHE PATENTSCHRIFT

(45) Veröffentlichungstag der Patentschrift :
30.07.86

(21) Anmeldenummer : 83105323.6

(22) Anmeldetag : 30.05.83

(51) Int. Cl.⁴ : **G 03 C   1/54**, G 03 F   3/10,
C 08 G 61/12

(54) **Mit Wasser entwickelbares lichtempfindliches Gemisch und daraus hergestelltes lichtempfindliches Kopiermaterial.**

(30) Priorität : 03.06.82 US 384457
17.01.83 US 458408

(43) Veröffentlichungstag der Anmeldung :
21.12.83 Patentblatt 83/51

(45) Bekanntmachung des Hinweises auf die Patenterteilung : 30.07.86 Patentblatt 86/31

(84) Benannte Vertragsstaaten :
DE

(56) Entgegenhaltungen :
DD-A-    91 767
DE-A- 2 024 242
DE-A- 2 024 243
DE-A- 2 032 947
DE-A- 2 739 774
Die Akte enthält technische Angaben, die nach dem
Eingang der Anmeldung eingereicht wurden und die
nicht in dieser Patentschrift enthalten sind.

(73) Patentinhaber : AMERICAN HOECHST CORPORA-
TION
Route 202-206 North
Somerville, N.J. 08876 (US)

(72) Erfinder : Barton, Oliver A.
49 Afton Drive
Florham Park New Jersey 07932 (US)
Erfinder : Wright, James D.
286 South Maple Avenue
Basking Ridge New Jersey 07920 (US)

(74) Vertreter : Euler, Kurt Emil, Dr.
KALLE Niederlassung der Hoechst AG Rheingaustrasse 190 Postfach 3540
D-6200 Wiesbaden 1 (DE)

## Beschreibung

Die Erfindung betrifft ein lichtempfindliches Gemisch auf Basis von Diazoniumsalz-Polykondensationsprodukten sowie ein entsprechendes lichtempfindliches Kopiermaterial, das zur Herstellung von Farbprüffolien geeignet ist.

Die Herstellung von Farbprüffolien mittels lichtempfindlicher Materialien auf Basis von Diazoniumsalz-Polykondensationsprodukten ist aus der DE-C 20 32 947 und der DE-A 24 10 287 bekannt. Dort werden als lichtempfindliche Verbindungen Polykondensationsprodukte aus einem Diazoniumsalz und einer kondensationsfähigen Zweitkomponente, insbesondere aus Diphenylamin-4-diazoniumsalzen und 4,4'-Bis-methoxymethyl-diphenylether, eingesetzt.

Diese Farbprüffolien bestehen im allgemeinen aus einem transparenten Schichtträger, auf den ein lichtempfindliches Gemisch aus dem Polykondensationsprodukt und einem Farbstoff, gewöhnlich in den Farben Blaugrün (Cyan), Purpur (Magenta), Gelb oder Schwarz, aufgebracht wird. Nach dem Belichten der Farbprüffolie unter der Vorlage und Entwickeln entsteht ein Transparentbild, das einer der Farben der Vorlage entspricht. Für jede der obengenannten Grundfarben wird eine Farbprüffolie angefertigt, so daß man eine Serie von Transparenten enthält, die jeweils eine Farbe der Vorlage wiedergeben. Werden diese Transparente übereinandergelegt, so entsteht ein Bild, das der Vorlage sehr nahekommt.

Bei diesem Verfahren besteht die Schwierigkeit, daß die normalerweise für die Herstellung der Farbprüffolien verwendeten lichtempfindlichen Gemische mit Entwicklern behandelt werden müssen, die umweltschädliche Lösemittel, ätzende Substanzen und andere ähnliche Bestandteile enthalten. Seit langem möchte man eine Farbprüffolie herstellen, die sich mit gewöhnlichem Leitungswasser in einem für die Praxis annehmbaren Maß entwicklen läßt. Das ist bisher nicht gelungen. Bei dem Versuch, solche Bilder durch Entwickeln mit Wasser zu erzeugen, treten erhebliche Probleme beim Entwickeln auf, und es wird eine schlechte Bildqualität erhalten.

Aufgabe der Erfindung war es, ein lichtempfindliches Gemisch auf Basis von Diazoniumsalz-Polykondensationsprodukten vorzuschlagen, aus dem ein lichtempfindliches Material hergestellt werden kann, das sich leicht mit Wasser entwickeln läßt und dessen belichtete Bereiche in feuchtem Zustand eine gute Haftung auf Schichtträgern aus Kunststoffolien aufweisen.

Erfindungsgemäß wird ein lichtempfindliches Gemisch vorgeschlagen, das als wesentliche Bestandteile mindestens ein lichtempfindliches Polykondensationsprodukt aus 3-Methoxy-diphenylamin-4-diazoniumsalz und 4,4'-Bis-methoxymethyl-diphenylether als Salz einer organischen Sulfonsäure, mindestens ein Farbmittel und mindestens ein polymeres Bindemittel enthält.

Das erfindungsgemäße Gemisch ist dadurch gekennzeichnet, daß das Polykondensationsprodukt in Form eines Gemischs aus zwei Polykondensationsprodukten eingesetzt wird, wovon das eine als Methansulfonat und das andere als Mesitylensulfonat vorliegt, und daß das polymere Bindemittel wasserlöslich ist.

Erfindungsgemäß wird ferner ein lichtempfindliches Material zur Herstellung von Farbprüffolien vorgeschlagen, das aus einem Schichtträger und einer lichtempfindlichen Schicht besteht, die als wesentliche Bestandteile mindestens ein lichtempfindliches Polykondensationsprodukt aus 3-Methoxy-diphenylamin-4-diazoniumsalz und 4,4'-Bis-methoxymethyl-diphenylether als Salz einer organischen Sulfonsäure, mindestens ein Farbmittel und mindestens ein polymeres Bindemittel enthält.

Das erfindungsgemäße Material ist dadurch gekennzeichnet, daß das Polykondensationsprodukt in Form eines Gemischs aus zwei Polykondensationsprodukten eingesetzt wird, wovon das eine als Methansulfonat und das andere als Mesitylensulfonat vorliegt, und daß das polymere Bindemittel wasserlöslich ist.

In der bevorzugten Ausführung ist der Schichtträger eine transparente Kunststoffolie und besteht insbesondere aus Polyethylenterephthalat. Zur Verbesserung der Oberflächeneigenschaften, z. B. des Haftungsvermögens, kann die Trägeroberfläche gegebenenfalls in bekannter Weise vorbehandelt werden. Solche Vorbehandlung ist z. B. das Beschichten mit Acrylverbindungen oder Polyvinylidenchlorid.

Für die Herstellung des lichtempfindlichen Beschichtungsgemischs werden zwei verschiedene lichtempfindliche Bestandteile verwendet, nämlich

Diazo 1 :
das Polykondensationsprodukt aus 3-Methoxy-diphenylamin-4-diazoniumsulfat und 4,4'-Bis-methoxymethyl-diphenylether, ausgefällt als Methansulfonat und

Diazo 2 :
das Polykondensationsprodukt aus 3-Methoxy-diphenylmin-4-diazoniumsulfat und 4,4'-Bis-methoxymethyl-diphenylether, ausgefällt als Mesitylensulfonat.

Überraschenderweise hat sich gezeigt, daß man bei Verwendung einer Kombination aus diesen beiden Verbindungen in der Beschichtungsmischung die obengenannten günstigen Eigenschaften erhält, wogegen diese Vorteile nicht zu erkennen sind, wenn eine der beiden lichtempfindlichen Substanzen weggelassen wird.

Das Beschichtungsgemisch enthält ferner mindestens ein wasserlösliches polymeres Harz als Bindemittel. In der bevorzugten Ausführung ist dieses Harz Polyvinylpyrrolidon, das vorzugsweise ein durchschnittliches Molgewicht von etwa 60 000 bis 300 000 aufweist. Die Beschichtung enthält außerdem mindestens ein verträgliches Farbmittel, vorzugsweise einen Farbstoff. Das am besten geeignete Farbmittel und das beste Harz können vom Fachmann leicht bestimmt werden.

Farbprüffolien können zwar mit einer Vielzahl von Farbtönen hergestellt werden, für Flachdruckzwecke sind jedoch Gelb, Magenta, Cyan und Schwarz am besten geeignet.

In der bevorzugten Ausführung liegt das Verhältnis Diazo 1 : Diazo 2 im Bereich von etwa 1 : 3,5 bis etwa 3,5 : 1, bevorzugt 1 : 1 bis 1 : 3,5.

Der Gesamtanteil der Diazoverbindungen in der Beschichtungslösung liegt vorzugsweise im Bereich von etwa 6 bis 60, insbesondere bei etwa 10 bis 45 Gewichtsteilen, bezogen auf 100 Gewichtsteile aller nichtflüchtigen Bestandteile in der Beschichtungslösung.

Der Gesamtanteil an Farbmittel in der Beschichtungslösung liegt vorzugsweise im Bereich von etwa 3 bis 60, insbesondere bei etwa 4 bis 33 Gewichtsteilen. Der Harzanteil in der Beschichtungslösung beträgt vorzugsweise etwa 10 bis 90, insbesondere etwa 33 bis 80 Gewichtsteile, jeweils bezogen auf die gleiche Basis wie oben.

Im übrigen enthält die Beschichtungslösung ein Lösemittelgemisch in einer Menge, die ausreicht, um die Masse effektiv lösen und auftragen zu können. Nach dem Auftragen der Beschichtung läßt man das Lösemittelgemisch trocknen, wobei jedoch geringe Lösemittelrückstände in der Beschichtung bleiben können.

Die lichtempfindliche Schicht wird vorzugsweise in einer Menge von etwa 0,025 bis 10 g/m$^2$, insbesondere von 0,05 bis 2,0 g/m$^2$, bezogen auf Feststoffe, auf den Träger aufgebracht.

Die bevorzugten Farbmittel sind Farbstoffe ; dabei werden insbesondere Viktoriareinblau FGA, Rhodamin FB und Calcozine Yellow sowie Kombinationen dieser Farbstoffe verwendet.

Geeignete Lösemittel sind zum Beispiel Ethylenglykolmonomethylether, Ethylenglykolmonoethylether, Butanon, Propanol, Isopropanol, Methylpentylketon, Methylbutylketon und Methanol. Das bevorzugte Lösemittelgemisch besteht aus einer Mischung von Ethylenglykolmonomethylether (2-Methoxyethanol) und Butanon im Verhältnis 1 : 1.

Gegebenenfalls kann die Beschichtung noch weitere Bestandteile in geringen Mengen enthalten. Solche Bestandteile sind u. a. die dem Fachmann bekannten Stabilisatoren, z. B. p-Toluolsulfonsäure.

Die Vorteile der Erfindung werden durch die nachfolgenden Beispiele näher erläutert :

## Beispiel 1

Durch Mischen aller Bestandteile bei normalen Raumbedingungen werden die folgenden Beschichtungsgemische hergestellt :

| Komponente | Lösung | | |
|---|---|---|---|
| | A | B | A + B |
| 2-Methoxy-ethanol/Butanon (1:1) | 95,0 g | 95,0 g | 95,0 g |
| Viktoriareinblau FGA (C.I. Basic Blue 81) | 0,5 g | 0,5 g | 0,5 g |
| Polyvinylpyrrolidon (K-60) (GAF) | 4,0 g | 4,0 g | 4,0 g |
| Diazo 1 | 0,5 g | 0 | 0,25 g |
| Diazo 2 | 0 | 0,5 | 0,25 g |

Die Lösungen A, B und A + B werden auf Folien aus Polyethylenterephthalat (Melinex® 505 von ICI) zu einer optischen Dichte von 16-20 auf der Gardner-Skala aufgetragen, dann getrocknet und 3 Minuten auf 60 °C erhitzt. Die Beschichtungen werden 20 Sekunden in einem handelsüblichen Belichtungsgerät durch ein Negativ belichtet und mit Wasser entwickelt. Dabei zeigt sich, daß Probe A nicht mit Wasser entwickelt werden kann. Probe B läßt sich nur mit Wasser entwickeln, wenn sie gleichzeitig gerieben wird. Probe A + B läßt sich dagegen durch bloßes Aufsprühen von Wasser entwickeln und ergibt trotzdem eine gute Haftung des feuchten Bildes auf dem Träger.

## Beispiel 2

Es wird wie in Beispiel 1 gearbeitet, wobei die Beschichtungsmischung jedoch folgende Feststoffe enthält :

3

| Polyvinylpyrrolidon (K-60) (GAF) | 600,0 g |
|---|---|
| Polyvinylpyrrolidon (K-90) (GAF) | 175,0 g |
| Viktoriareinblau FGA (C.I. Basic Blue 81) | 160,0 g |
| Diazo 1 | 180,0 g |
| Diazo 2 | 500,0 g |
| p-Toluolsulfonsäure | 7,5 g |

Die Lösung wird zu einer Dichte von 1,25-1,30 (Blaugrünfilter) aufgetragen und bei 65 °C getrocknet. Anschließend wird die Beschichtung belichtet und unter sehr leichtem Überwischen mit Wasser entwickelt. Es entsteht ein vollständig ausentwickeltes Produkt mit ausgezeichneter Haftung des feuchten Bildes.

## Beispiel 3

Die folgenden nach dem Verfahren des Beispiels 1 hergestellten Beschichtungsgemische werden zwei Minuten auf den Träger aufgeschleudert und bei 100 °C vier Minuten nachgetrocknet :

| Komponente | Lösung | | |
|---|---|---|---|
| | A | B | A + B |
| 2-Methoxy-ethanol/Butanon (1:1) | 93,4 g | 93,4 g | 93,4 g |
| Viktoriareinblau FGA (C.I. Basic Blue 81) | 0,6 g | 0,6 g | 0,6 g |
| Polyvinylpyrrolidon (K-60) (GAF) | 4,0 g | 4,0 g | 4,0 g |
| Diazo 1 | 3,0 g | 0 | 1,5 g |
| Diazo 2 | 0 | 3,0 | 1,5 g |

Bei dem Versuch, mit Wasser zu entwickeln, bleiben bei der Probe A die bildfreien Stellen gefärbt. Probe B muß beim Entwickeln gerieben werden und zeigt trotzdem noch eine sichtbare Hintergrundfärbung ; die Haftung des feuchten Bildes ist allerdings sehr gut. Die Probe A + B läßt sich durch Besprühen mit Wasser leicht entwickeln und weist eine minimale Verfärbung des Hintergrundes und eine gute Haftung des feuchten Bildes auf.

## Beispiel 4

Es werden die folgenden Beschichtungsgemische hergestellt, ohne Wärmebehandlung aufgetragen, belichtet und entwickelt :

| Komponente | Lösung | | |
|---|---|---|---|
| | A | B | A + B |
| 2-Methoxy-ethanol/Butanon (1:1) | 92,2 g | 92,2 g | 92,2 g |
| Polyvinylpyrrolidon (K-60) (GAF) | 1,0 g | 1,0 g | 1,0 g |
| Viktoriareinblau FGA (C.I. Basic Blue 81) | 1,0 g | 1,0 g | 1,0 g |
| Rhodamin FB | 0,6 g | 0,6 g | 0,6 g |
| Calcozine Yellow (C.I. 41 001) | 0,6 g | 0,6 g | 0,6 g |
| Diazo 1 | 4,0 g | 0 | 2,0 g |
| Diazo 2 | 0 | 4,0 | 2,0 g |

Probe A läßt sich durch Besprühen mit Wasser entwickeln, ergibt jedoch eine schlechte Haftung des feuchten Bildes. Probe B läßt sich mit Wasser nicht vollständig entwickeln. Probe A + B läßt sich durch Besprühen mit Wasser und leichtes Reiben entwickeln, zeigt eine minimale Verfärbung des Hintergrundes und gute Haftung des feuchten Bildes.

**Patentansprüche**

1. Lichtempfindliches Gemisch, das als wesentliche Bestandteile mindestens ein lichtempfindliches Polykondensationsprodukt aus 3-Methoxy-diphenylamin-4-diazoniumsalz und 4,4'-Bis-methoxymethyl-diphenylether als Salz einer organischen Sulfonsäure, mindestens ein Farbmittel und mindestens ein polymeres Bindemittel enthält, dadurch gekennzeichnet, daß das Polykondensationsprodukt in Form eines Gemischs aus zwei Polykondensationsprodukten eingesetzt wird, wovon das eine als Methansulfonat und das andere als Metisylensulfonat vorliegt, und daß das polymere Bindemittel wasserlöslich ist.

2. Lichtempfindliches Gemisch nach Anspruch 1, dadurch gekennzeichnet, daß das wasserlösliche polymere Bindemittel Polyvinylpyrrolidon ist.

3. Lichtempfindliches Gemisch nach Anspruch 1, dadurch gekennzeichnet, daß das Farbmittel ein Farbstoff ist.

4. Lichtempfindliches Gemisch nach Anspruch 1, dadurch gekennzeichnet, daß das Methansulfonat und das Mesitylensulfonat im Gewichtsverhältnis 3,5 : 1 bis 1 : 3,5 vorliegen.

5. Lichtempfindliches Gemisch nach Anspruch 1, dadurch gekennzeichnet, daß es 6 bis 60 Gew.-%, bezogen auf seine nichtflüchtigen Bestandteile, an Diazoniumsalz-Polykondensationsprodukten enthält.

6. Lichtempfindliches Material zur Herstellung von Farbprüffolien, bestehend aus einem Schichtträger und einer lichtempfindlichen Schicht, die als wesentliche Bestandteile mindestens ein lichtempfindliches Polykondensationsprodukt aus 3-Methoxy-diphenylamin-4-diazoniumsalz und 4,4'-Bis-methoxymethyl-diphenylether als Salz einer organischen Sulfonsäure, mindestens ein Farbmittel und mindestens ein polymeres Bindemittel enthält, dadurch gekennzeichnet, daß das Polykondensationsprodukt in Form eines Gemischs aus zwei Polykondensationsprodukten eingesetzt wird, wovon das eine als Methansulfonat und das andere als Mesitylsulfonat vorliegt, und daß das polymere Bindemittel wasserlöslich ist.

7. Lichtempfindliches Material nach Anspruch 6, dadurch gekennzeichnet, daß der Schichtträger eine transparente Kunststoffolie ist.

**Claims**

1. A photosensitive mixture comprising, as its essential ingredients, at least one photosensitive polycondensation product of a 3-methoxy-diphenylamine-4-diazonium salt and 4,4'-bis-methoxymethyl-diphenyl ether in form of the salt of an organic sulfonic acid, at least one colorant, and at least one polymeric binder, characterized in that the polycondensation product is used in the form of a mixture of two polycondensation products, one of which being present as the methane sulfonate and the other as the mesitylene sulfonate, and that the polymeric binder is water-soluble.

2. A photosensitive mixture as claimed in claim 1 wherein said binder is polyvinyl pyrrolidone.

3. A photosensitive mixture as claimed in claim 1 wherein said colorant is a dye.

4. A photosensitive mixture as claimed in claim 1 wherein the methane sulfonate and the mesitylene sulfonate are present in a weight ratio from 3.5 : 1 to 1 : 3.5.

5. A photosensitive mixture as claimed in claim 1 which comprises from 6 % to 60 %, based on its nonvolatile ingredients, of diazonium salt polycondensation product.

6. A photosensitive material for the manufacture of colour proofing films consisting of a support and a photosensitive layer which comprises, as its essential ingradients, at least one photosensitive polycondensation product of a 3-methoxy-diphenylamine-4-diazonium salt and 4,4'-bis-methoxymethyl-diphenyl ether in form of the salt of an organic sulfonic acid, at least one colorant, and at least one polymeric binder, characterized in that the polycondensation product is used in the form of a mixture of two polycondensation products, one of which being present as the methane sulfonate and the other as the mesitylene sulfonate, and that the polymeric binder is water-soluble.

7. A material as claimed in claim 6 wherein said support is a transparent plastics film.

**Revendications**

1. Mélange photosensible qui contient en tant que constituants essentiels au moins un produit de polycondensation, photosensible, de sel de 3-méthoxy-diphénylamine-4-diazonium et de 4,4'-bis-méthoxyméthyl-diphényléther comme sel d'un acide sulfonique organique, au moins une substance colorante et au moins un liant polymère, mélange caractérisé en ce que le produit de polycondensation est utilisé sous la forme d'un mélange de deux produits de polycondensation, dont l'un se présente comme un méthane sulfonate et l'autre comme un mésitylènesulfonate, et en ce que le liant polymère est soluble dans l'eau.

2. Mélange photosensible selon la revendication 1, caractérisé en ce que le liant polymère photosensible soluble dans l'eau, est la polyvinylpyrrolidone.

**0 096 326**

3. Mélange photosensible selon la revendication 1, caractérisé en ce que la substance colorante est un colorant.

4. Mélange photosensible selon la revendication 1, caractérisé en ce que le méthane sulfonate et le mésitylène sulfonate sont présents dans un rapport pondéral de 3,5 : 1 à 1 : 3,5.

5. Mélange photosensible selon la revendication 1, caractérisé en ce qu'il contient de 6 à 60 % en poids, par rapport à ses constituants non volatils, de produits de polycondensation de sel de diazonium.

6. Matériau photosensible pour la préparation de feuilles pour épreuves de couleur, composé d'un support de couche et d'une couche photosensible, qui contient en tant que constituants essentiels au moins un produit de polycondensation, photosensible, de sel de 3-méthoxy-diphénylamine-4-diazonium et de 4,4'-bis-méthoxyméthyl-diphényléther comme sel d'un acide sulfonique organique, au moins une substance colorante et au moins un liant polymère, matériau caractérisé en ce que le produit de polycondensation est utilisé sous la forme d'un mélange de deux produits de polycondensation dont l'un est présent comme méthanesulfonate et l'autre comme mésitylènesulfonate, et en ce que le liant polymère est soluble dans l'eau.

7. Matériau photosensible selon la revendication 6, caractérisé en ce que le support de couche est une feuille de matière plastique transparente.

6